# EUROPEAN PATENT APPLICATION

(11) **EP 3 089 568 A1**
(43) Date of publication of application: **02.11.2016**
(21) Application number: 16000755.5
(22) Date of filing: 31.03.2016
(51) Int. Cl.: H05K 3/28, H05K 3/34

(54) **PRINTED WIRING BOARD, METHOD FOR PRODUCING PRINTED WIRING BOARD AND SEMICONDUCTOR DEVICE**

(30) Priority: 30.04.2015 JP 2015092554
(71) Applicant: Shin-Etsu Chemical Co., Ltd., Chiyoda-ku Tokyo (JP)
(72) Inventor: Kimura, Saiko, Annaka-shi, Gunma-ken (JP); Hamamoto, Yoshihira, Annaka-shi, Gunma-ken (JP); Kashiwagi, Tsutomu, Annaka-shi, Gunma-ken (JP)
(74) Representative: Wibbelmann, Jobst

(57) **Abstract**

The present invention provides a printed wiring board comprising: a conductor circuit on an insulating substrate, a white solder resist layer which is composed of a photosensitive resin composition on the insulating substrate having the conductor circuit, and a protective layer which is composed of a silicone resin composition on the white solder resist layer. The inventive printed wiring board shows superior thermo-discoloration resistivity and excellent patterning resolution.

## Description

### FIELD OF THE INVENTION

The present invention relates to a printed wiring board, a method for producing the printed wiring board, and a semiconductor device which is produced by using the printed wiring board.

### DESCRIPTION OF THE RELATED ART

In a production of a printed wiring board, a solder resist film is formed on a printed wiring board in order to protect a conductor circuit formed on an insulating substrate from an external environment and to prevent an exfoliation or an oxidation of the conductor circuit, or to protect a conductor circuit from adhesion of solder to a part where solder is not required in a soldering step performed in a surface mount of an electronic component to the printed wiring board.

As a method for forming a solder resist film, a screen printing method is generally known. However, it is difficult for a screen printing method to respond to fine patterning with higher density because of a restriction on a screen line width or a discrepancy of screen plates.

Accordingly, a photographic developing method is adopted, in which a photosensitive resin composition is applied to form a coat and then patterning is performed by a photographic method. A common photosensitive resin composition is composed of a photosensitive polymer with a functional group such as a carboxyl group, which is neutralized by an alkaline developer to dissolve, a crosslinking agent, a photo-curing initiator, a photo-curing sensitizer, a thermal curing initiator, filler, etc. For the photosensitive polymer and the crosslinking agent, epoxy resin is commonly used as a main component.

The resolution of a solder resist pattern is improved by the foregoing photosensitive resin composition. On the other hand, such a photosensitive resin composition shows poor discoloration resistivity to heat (thermo-discoloration resistivity) due to a use of an epoxy resin. Besides, a photo-curing initiator is induced to coloration and oxidative decomposition, which makes a solder resist film to change to yellow and lowers reflectance. In addition, a resent solder resist film is required to have superior thermo-discoloration resistivity because of a use of lead-free solder, which has high fusing point, or an increasing heating value of a LED element due to improving brightness of a LED.

As a method for producing a printed wiring board having a solder resist film with high reflectance, Patent Document 1 discloses a method for forming a solder resist film by screen printing method using a white reflection film composed of a silicone resin composition and a white inorganic filler. This can give a solder resist film with superior thermo-discoloration resistivity, but as described above, a screen printing method cannot deal with fine patterning.

On the other hand, Patent Documents 2 and 3 disclose a printed wiring board in which a layer composed of a photosensitive resin composition and a layer composed of a white thermo-setting resin composition thereon are formed. The under layer using a photosensitive resin composition realizes an improvement of resolution of a solder resist pattern, and the upper layer formed from a thermo-setting resin composition gives thermo-discoloration resistivity. However, Patent Document 2 does not refer to a thermo-setting resin composition to be used, and Patent Document 3 uses an epoxy resin as a thermo-setting resin. Although a use of a thermo-setting resin composition suppresses an influence of a photo-curing initiator, which is a cause of a discoloration, low heat-resistant resin such as an epoxy resin gives insufficient thermo-discoloration resistivity.

Accordingly, it has been required to develop a printed wiring board having a solder resist film which combines excellent thermo-discoloration resistivity and patterning resolution.

### Prior art documents

### Patent Documents

Patent Document 1: Japanese Unexamined Patent Application Publication No. 2013-226769
Patent Document 2: Japanese Unexamined Patent Application
Publication No. 2011-066267
Patent Document 3: Japanese Unexamined Patent Application
Publication No. 2011-049476

### SUMMARY OF THE INVENTION

The present invention was made in view of the above-described situations. It is an object of the present invention to provide a printed wiring board having a solder resist film with excellent thermo-discoloration resistivity and patterning resolution.

To solve the foregoing problem, the present invention provides a printed wiring board comprising: a conductor circuit on an insulating substrate, a white solder resist layer which is composed of a photosensitive resin composition on the insulating substrate having the conductor circuit, and a protective layer which is composed of a silicone resin composition on the white solder resist layer.

Such a printed wiring board enables to combine excellent thermo-discoloration resistivity and patterning resolution on account of a two-layered structure of a white solder resist layer composed of a photosensitive resin composition with good patterning resolution and a protective layer composed of a silicone resin composition having good heat resistance formed on the white solder resist layer.

Preferably, the white solder resist layer has an aperture having a width of d1 µm, the protective layer has an aperture having a width of d2 µm on the aperture of the white solder resist layer, and the width d1 and the width d2 satisfy 0 ≤ (d2-d1)/2 ≤ 500 µm.

Moreover, it is preferred that the aperture of the white solder resist layer is filled with plating.

When the white solder resist layer and the protective layer have such apertures as described above, these apertures can be filled with plating, and the white solder resist layer is sufficiently covered with the protective layer. Accordingly, it can minimize an influence of discoloration of the white solder resist layer, even if discoloration is occurred, and enables to further improve thermo-discoloration resistivity of the solder resist film.

It is preferred that the photosensitive resin composition contains an epoxy resin.

Such a composition which contains an epoxy resin can be a firm white solder resist layer with a good electric property and a good adhesive property to the conductor circuit.

Furthermore, it is preferred that the photosensitive resin composition contains a white pigment.

By using a photosensitive resin composition containing a white pigment, the reflectance of the white solder resist layer can be improved.

It is also preferred that the silicone resin composition is an addition curing silicone resin composition.

By using an addition curing silicone resin composition, heat resistance of the protective layer can be further improved.

Moreover, it is preferred that the silicone resin composition contains a silicone resin and a filler.

By using such a silicone resin composition, the heat resistance, reflectance, and strength of the protective layer can be further improved.

In this case, it is preferred that the filler contains a white pigment.

By using a silicone resin composition containing a white pigment, the reflectance of the protective layer can be improved.

The printed wiring board of the present invention can also be the one in which the conductor circuit has a mounting region to mount an electronic component, and the region excluding the mounting region is coated with the white solder resist layer and the protective layer.

The present invention also provides a semiconductor device which is produced by using the foregoing printed wiring board.

Such a semiconductor device shows high quality since it uses a printed wiring board with excellent thermo-discoloration resistivity and good patterning resolution.

The semiconductor device of the present invention can be used, remaining the formed protective layer.

The present invention also provides a method for producing a printed wiring board, comprising the steps of:
(1) forming a white solder resist layer on an insulating substrate having a conductor circuit by using a photosensitive resin composition, (2) forming an aperture in the white solder resist layer by a photolithography method, and (3) forming a protective layer on the white solder resist layer having the aperture by a printing method using a silicone resin composition, the protective layer being formed excluding the aperture and being provided with an aperture.

By such a producing method, it is possible to produce a printed wiring board having a solder resist film which combines excellent thermo-discoloration resistivity and patterning resolution on account of a two-layered structure of a white solder resist layer and a protective layer with high efficiency.

In this case, the foregoing method preferably comprises a step of filling the aperture of the white solder resist layer by plating prior to the step (3) or subsequent to the step (3).

By adding such a step, it is possible to efficiently produce a printed wiring board in which the aperture of the white solder resist layer is filled with plating.

As described above, the present invention provides a highly reliable printed wiring board having a two-layered solder resist film which combines excellent thermo-discoloration resistivity and patterning resolution on account of a two-layered structure of a white solder resist layer and a protective layer. It is also possible to improve the hardness or adhesive property of the solder resist film, and to lower the gas permeability by using an epoxy resin in the white solder resist layer. Accordingly, the printed wiring board of the present invention can be suitably used for an optical semiconductor device which requires superior thermo-discoloration resistivity, a high-performance semiconductor device which requires reliability and fine patterning, and so on. The semiconductor device which is produced by using the printed wiring board of the present invention can be used, remaining the formed protective layer. Furthermore, the inventive producing method can produce such a printed wiring board with high efficiency.

### BRIEF DESCRIPTION OF THE DRAWINGS

FIG. 1 is a cross-sectional view of an example of a printed wiring board of the present invention;
FIG. 2 is an enlarged cross-sectional view of an aperture of an example of the inventive printed wiring board;
FIG. 3 is a schematic diagram of the photomask used in the Examples;
FIG. 4 is a schematic diagram of the polyester mesh plate used in the Examples.

### DETAILED DESCRIPTION OF THE PREFERRED EMBODIMENTS

As described above, it has been required to develop a printed wiring board having a solder resist film which combines excellent thermo-discoloration resistivity and patterning resolution.

The present inventors have diligently investigated to solve the problem described above, and have found that the foregoing problem can be solved by the printed wiring board having a solder resist film with a two-layered structure which contains a white solder resist layer composed of a photosensitive resin composition and a protective layer composed of a silicone resin composition on a substrate, and thus have completed the present invention.

The present invention is a printed wiring board comprising: a conductor circuit on an insulating substrate, a white solder resist layer which is composed of a photosensitive resin composition on the insulating substrate having the conductor circuit, and a protective layer which is composed of a silicone resin composition on the white solder resist layer.

Hereinafter, the present inventions are specifically described, however, the present invention is not limited thereto. It is to be noted that Me represents a methyl group, Ph represents a phenyl group, and Vi represents a vinyl group in the present specification.

### <Printed wiring board>

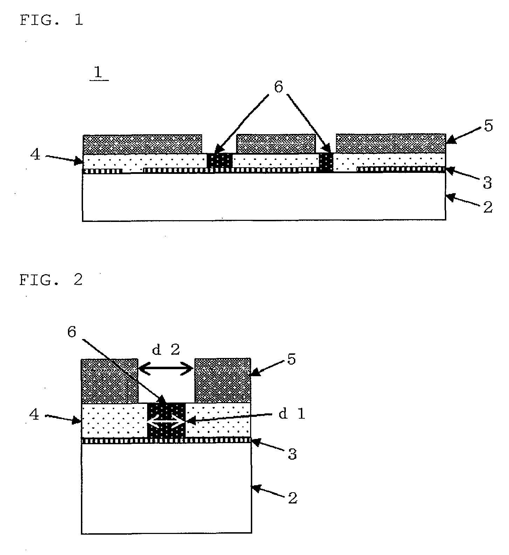

FIG. 1 is a cross-sectional view of an example of a printed wiring board of the present invention. The inventive printed wiring board 1 has a conductor circuit 3 on an insulating substrate 2, a white solder resist layer 4 which is composed of a photosensitive resin composition on the insulating substrate 2 having the conductor circuit 3, and a protective layer 5 which is composed of a silicone resin composition on the white solder resist layer 4. Besides, each the white solder resist layer 4 and the protective layer 5 may be provided with an aperture, and the aperture of the white solder resist layer 4 may be filled with plating 6, as shown in FIG. 1.

Hereinafter, the present inventions are more specifically explained.

### [Insulating substrate having conductor circuit]

An insulating substrate having a conductor circuit used in the inventive printed wiring board is not particularly limited, and anything generally used for a printed wiring board can be used.

### [White solder resist layer]

In the printed wiring board of the present invention, the white solder resist layer on the insulating substrate having the conductor circuit is a layer which is composed of a photosensitive resin composition. As the photosensitive resin composition used in the present invention, it is preferred to contain (A) a photo-polymerizable resin, (B) a photo-polymerization initiator, (C) a white pigment, and (D) a crosslinking agent.

### (A) Photo-polymerizable resin

As the photo-polymerizable resin of the component (A), it is possible to use a resin having both of the following groups: a group which enables to neutralization and dissolution to an alkaline developer (alkaline development) such as a carboxyl group or a phenolic hydroxyl group, and an ethylenic unsaturated group which gives photosensitivity such as an acryloyl group.

Such a photo-polymerizable resin is not particularly limited, and illustrative examples thereof include an epoxy acrylate resin obtained by introducing an ethylenic unsaturated group and a carboxyl group into a bisphenol type or novolac type epoxy resin, an acrylic resin obtained by introducing an ethylenic unsaturated group and optionally a carboxyl group into an acrylic resin having an epoxy group or a carboxyl group on its side chain, polyester type resin obtained by reacting an unsaturated fatty acid to a polyester resin having a carboxyl group and a hydroxyl group in its molecule.

### (B) Photo-polymerization initiator

The photo-polymerization initiator of the component (B) is not particularly limited, and illustrative examples thereof include benzoin, benzoin methyl ether, benzoin ethyl ether, benzoin isopropyl ether, benzoin n-butyl ether, acetophenone, dimethyl amino acetophenone, 2,2-dimethoxy-2-phenyl acetophenone, 2,2-diethoxy-2-phenyl acetophenone, 2-hydroxy-2-methyl-1-phenylpropane-1-one, 1-hydroxycyclohexyl phenyl ketone, 2-methyl-1-[4-(methylthio)phenyl]-2-morpholino-propane-1-one, 4-(2-hydroxyethoxy)phenyl-2-(hydroxy-2-propyl), ketone, benzophenone, 4,4'-diethylaminobenzophenone, dichlorobenzophenone, 2-methylanthraquinone, 2-ethylanthraquinone, 2-tert-butylanthraquinone, 2-aminoanthraquinone, 2-methylthioxanthone, 2-ethylthioxanthone, 2-chlorothioxanthone, 2,4-dimethylthioxanthone, benzyl dimethyl ketal, acetophenone dimethyl ketal, ethyl p-dimethylaminobenzoate, and so on. These photo-polymerization initiators may be used one kind alone or in combination of two or more kinds.

A blending amount of the component (B) is preferably 1 to 50 parts by mass, and more preferably 2 to 25 parts by mass, with respect to 100 parts by mass of the component (A). When the blending amount of the component (B) is 1 to 50 parts by mass, photo-curing reaction of the component (A) proceeds favorably, patterning by exposure and development is facilitated. The foregoing blending amount also can suppress lowering of mechanical properties and a variation of color of the white solder resist layer. Moreover, it is favorable in view of cost.

### (C) White pigment

The white pigment of the component (C) is used as a white coloring agent to make an obtained solder resist layer white. As the white pigment, any conventional white pigment can be used without limitation, and favorable examples thereof include titanium dioxide, alumina, zirconium oxide, zinc sulfide, zinc oxide, magnesium oxide, barium sulfate, and so on. Among these, titanium dioxide, alumina, and magnesium oxide are more preferable; and titanium dioxide is particularly preferable. Although the crystal form of titanium dioxide can be any of rutile-type, anatase-type, and brookite-type; rutile-type is preferable. These white pigments may be used one kind alone or in combination of two or more kinds.

The average particle diameter and the shape of the white pigment are not particularly limited, however, the average particle diameter of 0.05 to 10.0 µm is preferable, 0.1 to 5.0 µm is more preferable, and 0.1 to 1.0 µm is particularly preferable. Incidentally, the average particle diameter can be obtained as a mass-average value D₅₀ (or a median diameter) in a particle size distribution measurement by a laser diffraction method.

A blending amount of the component (C) is preferably 1 to 700 parts by mass, more preferably 50 to 500 parts by mass, and particularly preferably 100 to 450 parts by mass, with respect to 100 parts by mass of the component (A). When the blending amount of the component (C) is 1 to 700 parts by mass, a white solder resist layer with good photo-curing property and high reflectance can be obtained.

### (D) Crosslinking agent

The crosslinking agent of the component (D) is not particularly limited, and illustrative examples thereof include an epoxy resin such as a bisphenol A type epoxy resin, a bisphenol F type epoxy resin, a bisphenol S type epoxy resin, a phenol novolac type epoxy resin, a cresol novolac type epoxy resin, and an alicyclic epoxy resin; an acrylic resin; a polyester resin; a polyether resin; a phenol resin; polyvinyl alcohol; a polyamide resin; and so on. In these resins, epoxy resin is particularly preferable. These crosslinking agents may be used one kind alone or in combination of two or more kinds.

A blending amount of the component (D) is preferably 5 to 70 parts by mass, and more preferably 5 to 60 parts by mass, with respect to 100 parts by mass of the component (A). If the blending amount of the component (D) is 5 to 70 parts by mass, a firm white solder resist layer with improved electric property, heat-resistivity to soldering, and chemical resistance can be obtained without developing remnant when forming a white solder resist layer.

In the photosensitive resin composition used in the present invention, a known curing accelerator can be optionally blended as a reaction accelerator used with the component (D) to promote a post-cure of the white solder resist layer. Illustrative examples of such a curing accelerator include melamine compound, imidazole compound, phenol compound, and so on.

It is preferable for the photosensitive resin composition used in the present invention to contain epoxy resin. An epoxy resin can be contained as the foregoing component (A) or component (D). When the photosensitive resin composition contains an epoxy resin, a firm white solder resist layer with good electric property and adhesive property to a conductor circuit can be obtained.

The photosensitive resin composition used in the present invention may optionally contain various additives in addition to the foregoing components: for example, talc which is not a white pigment; silica such as fused silica, fused spherical silica, crystalline silica; inorganic filler such as silicon nitride, aluminum nitride, and boron nitride; an additive for a coating material such as a deforming agent, a leveling agent; a diluent, a thickener, a thermal-polymerization inhibitor, a coupling agent, a flame retardant, and so on may be blended.

The producing method for a photosensitive resin composition used in the present invention is not particularly limited. The photosensitive resin composition can be produced, for example, by blending the foregoing components (A) to (D) and other optional additives in certain ratios, and then kneading or mixing them at room temperature by a kneading means such as a three-roll mill, a ball mill, and a sand mill; or a stirring means such as a super mixer and a planetary mixer. Prior to the foregoing kneading or mixing, pre-kneading or pre-mixing may be optionally performed.

### [Protective layer]

In the printed wiring board of the present invention, a protective layer is formed on the foregoing white solder resist layer, and the protective layer is composed of a silicone resin composition. As the silicone resin composition used in the present invention, an addition curing silicone resin composition is preferable, and more specifically, a silicone resin composition which contains the following components (E) to (G) is preferable:
(E) an organopolysiloxane shown by the following average composition formula:

   (SiO₂) ₐ (R¹₁₋ₘR²ₘSiO_{1.5}) _{b} (R¹₂₋ₙR²ₙSiO) _{c} (R¹_{3-L}R²SiO_{0.5}) _{d}

   wherein R¹ represents a monovalent saturated hydrocarbon group having 1 to 10 carbon atoms or a monovalent aromatic hydrocarbon group having 6 to 12 carbon atoms, R² represents a monovalent unsaturated hydrocarbon group having 2 to 8 carbon atoms; m=0 to 1, n=0 to 2, L=0 to 3, and 1≤m+n+L≤6; and a, b, c, and d are numbers satisfying 0≤a≤1, 0≤b≤1, 0≤c≤0.9, 0≤d≤0.9, a+b>0, and a+b+c+d=1 (F) hydrogenpolysiloxane having one or more hydrogen atoms bound to a silicon atom (in the following, also called as a "SiH group");
(G) a platinum group metal based catalyst in an amount effective for curing.

### (E) Organopolysiloxane

The organopolysiloxane of the component (E) is an organopolysiloxane shown by the foregoing average composition formula. In the component (E), (SiO₂) unit and/or (R¹ₗ₋ₘR²ₘSiO_{1.5}) unit is/are essential. The protection layer has a sufficient hardness by containing such component (E).

In the foregoing formula, R¹ represents a monovalent saturated hydrocarbon group having 1 to 10 carbon atoms or a monovalent aromatic hydrocarbon group having 6 to 12 carbon atoms; and illustrative examples thereof include an alkyl group such as a methyl group, an ethyl group, a propyl group, an isopropyl group, a butyl group, an isobutyl group, a cyclohexyl group; an aryl group such as a phenyl group, a tolyl group, a xylyl group, a naphthyl group. Among these, a methyl group and a phenyl group are particularly preferable.

In the foregoing formula, R² represents a monovalent unsaturated hydrocarbon group having 2 to 8 carbon atoms; and illustrative examples thereof include an alkenyl group such as a vinyl group, an allyl group, a propenyl group, an isopropenyl group, and so on. Among these, a vinyl group is particularly preferable.

Illustrative examples of the component (E) include an organopolysiloxane which contains any two units or all of the three units of a (R¹₁₋ₘR²ₘSiO_{1.5}) unit, a (R¹₂₋ₙR²ₙSiO) unit, and a (R¹_{3-L}R²_{L}SiO_{0.5}) unit; an organopolysiloxane which contains a (R¹₁₋ₘR²ₘSiO_{1.5}) unit alone; an organopolysiloxane which contains a (SiO₂) unit and a (R¹_{3-L}R²_{L}SiO_{0.5}) unit; although the component (E) is not limited thereto.

Illustrative examples of the organopolysiloxane which contains any two units or all of the three units of a (R¹₁-mR²mSiO_{1.5}) unit, a (R¹₂₋ₙR²ₙSiO) unit, and a (R¹_{3-L}R²_{L}SiO_{0.5}) unit are shown below;
(PhSiO_{1.5}) ₑ₁ (Me₂SiO) _{f1} (Me₂ViSiO_{0.5}) _{G1}
(PhSiO_{1.5}) ₑ₁ (Me₂SiO) _{f1} (MeVi₂SiO_{0.5}) _{G1}
(PhSiO_{1.5})ₑ₂ (Me₂SiO) _{H} (MeViSiO) i (Me₂ViSiO_{0.5}) _{G2}
(Me₂SiO) _{f2} (Me₂ViSiO_{0.5}) _{G3}
(Me₂SiO) _{f3} (PhMeSiO) _{f4} (Me₂ViSiO_{0.5}) _{G3}
wherein e1, e2, f1, f2, f3, f4, G1, G2, G3, H, and i each represents a number satisfying 0.24≤e1≤0.9, 0.24≤e2≤0.9, 0.09≤f1≤0.9, 0.09≤f2≤0.9, 0.09≤f3≤0.9, 0.09≤f4≤0.9, 0≤G1≤0.5, 0≤G2≤0.5, 0≤G3≤0.5, 0.01≤H≤0.74, 0.01≤i≤0.74; and e1+f1+G1=1, e2+H+i+G2=1, f2+G3=1, and f3+f4+G3=1.

Illustrative example of the organopolysiloxane which contains a (R¹₁₋ₘR²ₘSiO_{1.5}) unit alone is shown below; (PhSiO_{1.5}) (ViSiO_{1.5}) ₖ, (MeSiO_{1.5})ⱼ (ViSiO_{1.5}) ₖ
wherein j and k each represents a number satisfying 0.5≤j≤0.95, 0.05≤k≤0.5, and j+k=1.

Illustrative examples of the organopolysiloxane which contains a (SiO₂) unit and a (R¹_{3-L}R²_{L}SiO_{0.5}) unit are shown below;

(SiO₂) ₛ (MesSiO_{0.5}) ₜ₁ (MePhViSiO_{0.5}) ₜ₂

(SiO₂) ₛ (Me₂ViSiO_{0.5}) ₜ₂

wherein s, t1, and t2 each represents a number satisfying 0.25≤s≤0.77, 0.02≤t1≤0.12, 0.18≤t2≤0.73; and s+t1+t2=1 or s+t2=1.

These organopolysiloxanes can be used one kind alone or in combination of two or more kinds. This component (E) preferably has a weight average molecular weight of 1,000 to 1,000,000 in terms of polystyrene. Such a weight average molecular weight gives good workability, curing property and so on.

The component (E) having such a resin structure can be synthesized by combining compounds of raw materials for each unit in such a way that each siloxane unit constitutes a desired molar ratio in a synthesized polymer, and then performing a co-hydrolysis condensation with a presence of an acid, for example. Incidentally, illustrative examples of the raw material for each siloxane unit include chlorosilanes, alkoxysilanes (such as methoxysilane), and so on which correspond to each siloxane unit.

### (F) Hydrogenpolysiloxane

The hydrogenpolysiloxane of the component (F) is a hydrogenpolysiloxane which contains one or more SiH groups. Illustrative examples of the component (F) include the following hydrogenpolysiloxane, but the component (F) is not particularly limited thereto. These hydrogen-polysiloxanes may be used one kind alone or in combination of two or more kinds.

(PhSiO_{1.5}) ₘ (Me₂SiO)ᵥ(Me₂HSiO_{0.5}) _{w1}

(PhSiO_{1.5})ᵤ₂ (Me₂SiO) ₓ (MeHSiO) y (Me₂HSiO_{0.5}) _{w2}

(PhSiO_{1.5})ᵤ₃ (MeHSiO) v, (MeSiO_{1.5})ᵤ₄ (MeHSiO)ᵥ

(Me₃SiO_{1/2}) ₂ (MeHSiO) _{z}

wherein u1, u2, u3, u4, v, w1, w2, x, and y each represents a number satisfying 0.24≤u1≤0.9, 0.24≤u2≤0.9, 0.24≤u3≤0.9, 0.24≤u4≤0.9, 0.09≤v≤0.75, 0.01≤w1≤0.5, 0.01≤w2≤0.5, 0.01≤x≤0.74, 0.01≤y≤0.74; and u1+v+w1=1, u2+x+y+w2=1, u3+v=1, and u4+v=1; and z is an integer of 1 to 20.

A blending amount of the component (F) is preferably an amount in such a way that a molar ratio of the SiH group of the component (F) with respect to the total monovalent unsaturated hydrocarbon group of the component (E) is 0.1 to 4.0, more preferably 0.5 to 3.0, particularly preferably 0.8 to 2.0. When the foregoing molar ratio is 0.1 or more, the curing reaction proceeds smoothly to give a cured product easily. When the foregoing molar ratio is 4.0 or less, it is possible to reduce the residue of unreacted SiH groups in a cured product, thereby suppressing a change in property of a cured product with the passage of time.

### (G) Platinum group metal based catalyst

A platinum group metal based catalyst of the component (G) is blended in order to perform an addition-curing reaction of the silicone resin composition, and illustrative examples thereof include a platinum based catalyst, a palladium based catalyst, and a rhodium based catalyst. As the catalyst, it is possible to use anything known to promote hydrosilylation reaction. Illustrative examples thereof with considering a cost and so on, include a platinum based catalyst such as platinum, platinum black, and chloroplatinic acid, for example, H₂PtCl₆·pH₂O, K₂PtCl₆, KHPtCl₆·pH₂O, K₂PtCl₄, K₂PtCl₄·pH₂O, PtO₂·pH₂O, PtCl₄·pH₂O, PtCl₂, H₂PtCl₄·pH₂O (wherein p is a positive integer); and each complex thereof with a hydrocarbon such as an olefin, an alcohol, or an organopolysiloxane which contains a vinyl group. These platinum group metal based catalysts may be used one kind alone or in combination of two or more kinds.

A blending amount of the component (G) may be an effective amount for curing, which is generally in a range of 0.1 to 500 ppm in terms of a mass of the platinum group metal, with respect to total amount of the component (E) and the component (F), and the range of 0.5 to 100 ppm is particularly preferable.

### (Filler)

In the silicone resin composition used in the present invention, filler may be optionally blended in order to improve the mechanical strength or reflectance of the protective layer. Such a filler is not particularly limited, and it is possible to use a known filler such as a white pigment to improve the reflectance, an inorganic filler to improve the mechanical property of the protective layer, and so on.

The filler preferably contains a white pigment. When the filler contains a white pigment, the filler may contain a white pigment only or contain both of a white pigment and an inorganic filler. Blending a white pigment enables to improve the reflectance of the protective layer, thereby gives a printed wiring board with high reflectance. Naturally, a white pigment is not required when the reflectance of the protective layer is not need to improve.

As the white pigment, it is possible to use any known white pigment conventionally used, not particularly limited, and illustrative examples thereof include titanium dioxide, alumina, zirconium oxide, zinc sulfide, zinc oxide, magnesium oxide, barium sulfate, and so on. Among these, titanium dioxide, alumina, and magnesium oxide are more preferable; and titanium dioxide is particularly preferable. Although the crystal form of titanium dioxide can be any of rutile-type, anatase-type, and brookite-type; rutile-type is preferable. These white pigments may be used one kind alone or in combination of two or more kinds.

The average particle diameter and the shape of the white pigment are not particularly limited, however, the average particle diameter of 0.05 to 10.0 µm is preferable, 0.1 to 5.0 µm is more preferable, and 0.1 to 1.0 µm is particularly preferable. Incidentally, the average particle diameter can be obtained as a mass-average value D₅₀ (or a median diameter) in a particle size distribution measurement by a laser diffraction method.

A blending amount of the white pigment is preferably 1 to 700 parts by mass, more preferably 50 to 500 parts by mass, and particularly preferably 100 to 450 parts by mass, with respect to 100 parts by the total mass of the silicone resin composition. When the blending amount of the white pigment is 1 to 700 parts by mass, a protective layer with high reflectance can be obtained.

As the filler, it is possible to blend an inorganic filler, which improves the mechanical strength of the protective layer. The inorganic filler may be any known inorganic filler, and illustrative examples thereof include silica such as precipitated silica, fumed silica, fused silica, fused spherical silica, crystalline silica; alumina; silicon nitride; aluminum nitride; boron nitride; antimony trioxide; and titanium dioxide. Among these, fused silica, fused spherical silica, and alumina are particularly preferable. These inorganic fillers may be used one kind alone or in combination of two or more kinds.

Incidentally, titanium dioxide, alumina, and so on can be both of a white pigment and an inorganic filler, and they can be blended to the composition as a filler to improve both of the strength and a reflectance of a protective layer.

As the filler, it is possible to use a filler previously subjected to surface treatment with a coupling agent such as a silane coupling agent, a titanate coupling agent, and so on to increase bond strength between the resin and the filler, if needed.

Preferable examples of the coupling agent include epoxy functional alkoxysilanes such as γ-glycidoxypropyltrimethoxysilane, γ-glycidoxypropylmethyldiethoxysilane, and β-(3,4-epoxycyclohexyl)ethyltrimethoxysilane; amino functional alkoxysilanes such as N-(β-aminoethyl)-γ-aminopropyltrimethoxysilane, γ-aminopropyltriethoxysilane, and N-phenyl-γ-aminopropyltrimethoxysilane; and mercapto functional alkoxysilanes such as γ-mercaptopropyl-trimethoxysilane. Incidentally, the blending amount of the coupling agent to be used for the surface treatment and a method of the surface treatment are not particularly limited.

The silicone resin composition used in the present invention may optionally contain any variable known additives other than the foregoing components.

### (Adhesion assistant)

The silicone resin composition used in the present invention may optionally contain an adhesion assistant (an adhesiveness provider) in order to give adhesiveness. Illustrative examples of the adhesion assistant include a linear or cyclic organosiloxane oligomer with at least two kinds, preferably two or three kinds of functional groups selected from a SiH group, an alkenyl group bound to a silicon atom (such as a Si-CH=CH₂ group), an alkoxysilyl group (such as a trimethoxysilyl group), and an epoxy group (such as a glycidoxypropyl group, 3,4-epoxycyclohexyl group) per molecule having about 4 to 50, preferably about 4 to 20 silicon atoms; an organooxysilyl modified isocyanurate compound shown by the following general formula (1), and its hydrolysis condensation product (organosiloxane modified isocyanurate compound). These adhesion assistants may be used one kind alone or in combination of two or more kinds. 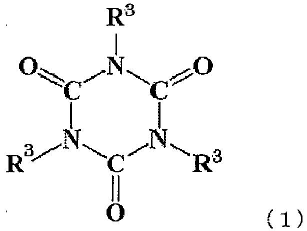 wherein R³ represents an organic group shown by the following partial structural formula (2) or a monovalent hydrocarbon group containing aliphatic unsaturated linkage, and at least one of the R³ is an organic group shown by the following partial structural formula (2). 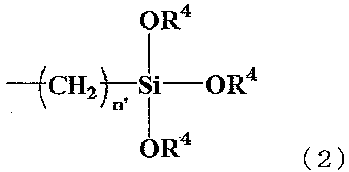 wherein R⁴ represents a hydrogen atom or a monovalent hydrocarbon group having 1 to 6 carbon atoms; and n' is an integer of 1 to 6, preferably 1 to 4.

Illustrative examples of the monovalent hydrocarbon group having an aliphatic unsaturated linkage of R³ in the foregoing general formula (1) include an alkenyl group having 2 to 8 carbon atoms, especially 2 to 6 carbon atoms such as a vinyl group, an allyl group, a propenyl group, an isopropenyl group, a butenyl group, an isobutenyl group, a pentenyl group, and a hexenyl group; and a cycloalkenyl group having 6 to 8 carbon atoms such as a cyclohexenyl group. Illustrative examples of the monovalent hydrocarbon group of R⁴ in the foregoing partial structural formula (2) include a monovalent hydrocarbon group having 1 to 8 carbon atoms, especially 1 to 6 carbon atoms such as an alkyl group including a methyl group, an ethyl group, a propyl group, an isopropyl group, a butyl group, an isobutyl group, a tert-butyl group, a pentyl group, a hexyl group; a cycloalkyl group including a cyclohexyl group; the alkenyl group and the cycloalkenyl group shown as examples of the foregoing R³; and an aryl group including a phenyl group. Among these, an alkyl group is preferable.

Illustrative examples of the adhesion assistant include 1,5-bis(glycidoxypropyl)-1,3,5,7-tetramethylcyclotetrasiloxane, 1-glycydoxypropyl-5-trimethoxysilylethyl-1,3,5,7-tetramethylcyclotetrasiloxane, and the siloxane compound shown by the following formula. 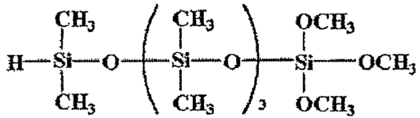 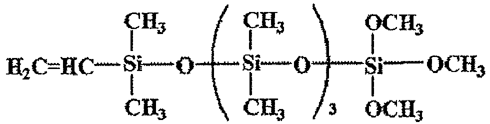 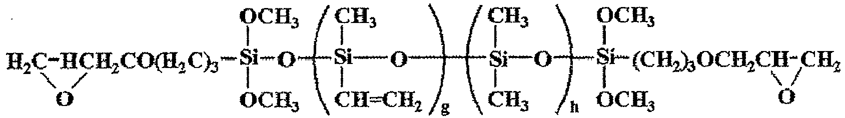 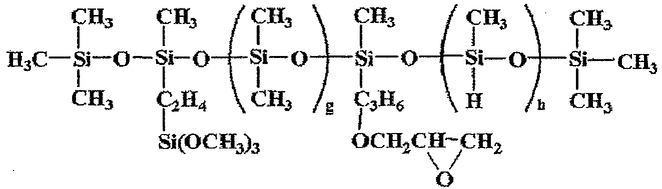 wherein each g and h is an integer in a range of 0 to 50 and satisfy g+h is 2 to 50, preferably 4 to 20.

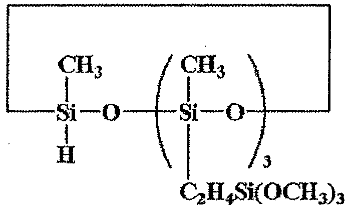

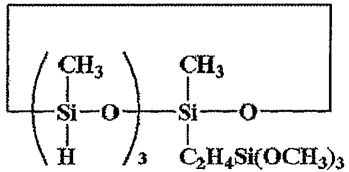

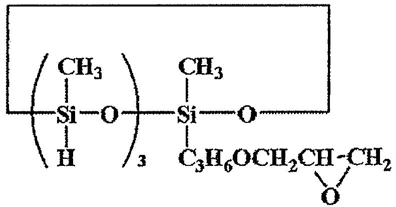

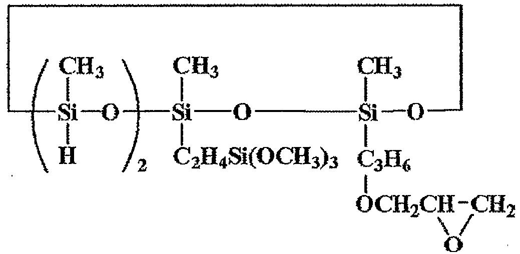

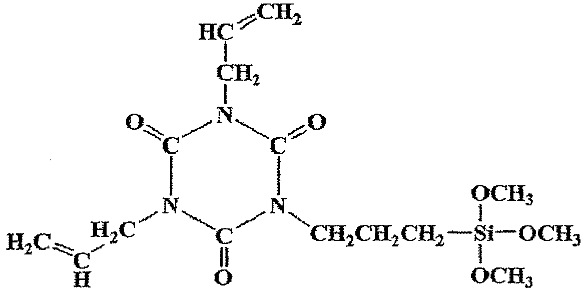

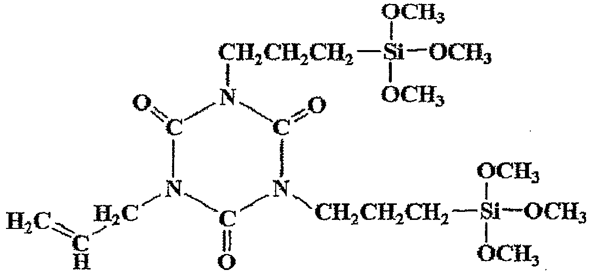

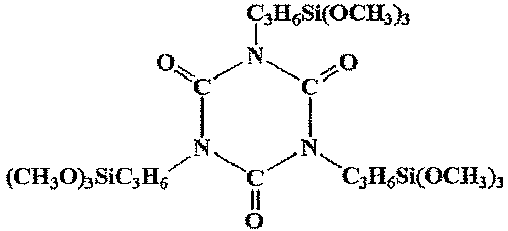

Among the foregoing siloxane compounds, the organosilicon compound having an alkoxy group bound to a silicon atom and an alkenyl group or a SiH group gives a cured product of the silicone resin composition with particularly favorable adhesive property.

A blending amount of the adhesion assistant is generally about 10 parts by mass or less (i.e., 0 to 10 parts by mass), preferably about 0.1 to 8 parts by mass, and more preferably about 0.2 to 5 parts by mass, with respect to 100 parts by mass of the silicone resin composition. In a cured product of the silicone resin composition, hardness is not influenced badly, and tackiness of the surface will not raise, when the blending amount of the adhesion assistant is 10 parts by mass or less.

### (Cure retarder)

The silicone resin composition used in the present invention may optionally contain a cure retarder. Illustrative examples of the cure retarder include compounds selected from the group consisting of an organopolysiloxane which contains vinyl groups in high content such as tetramethyltetravinylcyclotetrasiloxane, triallylisocyanurate, alkylmaleate, acetylene alcohols; a silane modified compound thereof, a siloxane modified compound thereof; hydroperoxide, tetramethylethylenediamine, benzotriazole, and a mixture thereof. These cure retarders may be used one kind alone or in combination of two or more kinds. A blending amount of the cure retarder is generally 0.001 to 1.0 parts by mass, and preferably 0.005 to 0.5 parts by mass, with respect to 100 parts by mass of the silicone resin composition.

The producing method for a silicone resin composition used in the present invention is not particularly limited. The silicone resin composition can be produced, for example, by blending the foregoing components (E) to (G) and other optional additives in certain ratios, and then kneading or mixing them at room temperature by a kneading means such as a three-roll mill, a ball mill, and a sand mill; or a stirring means such as a super mixer and a planetary mixer. Prior to the foregoing kneading or mixing, pre-kneading or pre-mixing may be optionally performed.

The printed wiring board of the present invention preferably has an aperture in its solder resist film. More specifically, it is preferred that the white solder resist layer 4 has an aperture having a width of d1 µm, the protective layer 5 has an aperture having a width of d2 µm on the aperture of the white solder resist layer 4, and the width d1 and the width d2 satisfy 0 ≤ (d2-d1)/2 ≤ 500 µm as shown in FIG. 2.

In this case, the aperture of the white solder resist layer 4 may be optionally filled with plating 6 as shown in FIG.1 and FIG. 2.

When the white solder resist layer and the protective layer have such apertures as described above, the aperture of the white solder resist layer can be filled with plating as described above, and the white solder resist layer is sufficiently covered with the protective layer. Accordingly, it can minimize an influence of discoloration of the white solder resist layer, even if discoloration occurs, and enables to further improve thermo-discoloration resistivity of the solder resist film.

The printed wiring board of the present invention may be the one in which the conductor circuit has a mounting region to mount an electronic component, and the region excluding the mounting region is coated with the white solder resist layer and the protective layer described above.

### <Method for producing printed wiring board>

The present invention also provides a method for producing the foregoing printed wiring board of the present invention. The method for producing a printed wiring board of the present invention is specifically a method comprising the steps of:
(1) forming a white solder resist layer on an insulating substrate having a conductor circuit by using a photosensitive resin composition,
(2) forming an aperture in the white solder resist layer by a photolithography method, and
(3) forming a protective layer on the white solder resist layer having the aperture by a printing method using a silicone resin composition, the protective layer being formed excluding the aperture and being provided with an aperture.

Hereinafter, each step will be specifically explained.

### [Step (1)]

In the method for producing a printed wiring board of the present invention, first, a white solder resist layer is formed on an insulating substrate having a conductor circuit by using a photosensitive resin composition as the step (1). As the photosensitive resin composition, the foregoing photosensitive resin composition may be used. These composition can be used with its viscosity adjusted appropriately to a coating method, for example, by diluting, and used in a state of liquid, paste, film, etc.

Illustrative examples of the coating method include a screen printing method, a curtain coating method, a spray coating method, a roll coating method, and so on. It is possible to form a tack-free white solder resist layer by optionally vaporized to dry the organic solvent contained in the composition, for example, at a temperature of 60 to 100°C after the coating. Alternatively, the white solder resist layer can be formed by putting the photosensitive resin composition formed into a film onto an insulating substrate having a conductor circuit, for example, by laminating method.

### [Step (2)]

Then, an aperture is formed in the white solder resist layer formed in the step (1), by a photolithography method as the step (2). In this step, a resist pattern (the aperture) can be formed, for example, by exposing the white solder resist layer using active energy beam via a photomask having a desired exposing pattern and then developing by dilute aqueous alkaline solution (eliminating exposed part).

Illustrative examples of the active energy beam (a light source) used for the exposure include low pressure mercury lamp, middle pressure mercury lamp, high pressure mercury lamp, super-high pressure mercury lamp, xenon lamp, metal halide lamp. Alternatively, laser beam and so on can be used as a light source.

As the aqueous dilute alkaline solution used for the development, 0.5 to 5% by mass aqueous sodium carbonate solution is usual, but other dilute aqueous alkaline solution can also be used. Illustrative examples of the other dilute aqueous alkaline solution include aqueous potassium hydroxide solution, aqueous sodium hydroxide solution, aqueous potassium carbonate solution, aqueous sodium phosphate solution, aqueous sodium silicate solution, aqueous ammonia, aqueous solution of amines.

In order to improve the heat resistance of the white solder resist layer thus obtained, it is desirable to perform post-curing of the white solder resist layer by heating at 100 to 200°C, or illuminating ultraviolet ray or far-infrared ray after forming the aperture.

### [Step (3)]

Then, a protective layer having an aperture is formed as a step (3) by a printing method using a silicone resin composition onto the area of the white solder resist layer, in which the aperture have been formed in the step (2), excluding the aperture. In this step, the white solder resist layer is covered with a mask for printing corresponding to a pattern (the aperture) of the white solder resist layer formed in the step (2), and then a silicone resin composition is applied by a screen printing method. As the silicone resin composition, the foregoing silicone resin composition may be used. These composition can be used with its viscosity adjusted appropriately, for example, by diluting, and used in a state of liquid, paste, film, etc.

It is possible to perform a step of filling the aperture of the white solder resist layer by plating prior to the step (3) or subsequent to the step (3).

The plating can be performed by an ordinal method, and the method is not particularly limited. Illustrative examples thereof include a method for forming a metal coating layer by either or both of an electroplating method or an electroless plating method. The coating metal layer is preferably selected from Ni, Pd, Au, Ag, Sn; alloys composed of two or more of these metals such as Ni-Au alloy, Ni-Ag alloy, Ni-Pd-Au alloy, and so on.

Such an inventive producing method enables to efficiently produce a printed wiring board of the present invention having a solder resist film which combines excellent thermo-discoloration resistivity and patterning resolution on account of a two-layered structure of a white solder resist layer and a protective layer.

### <Semiconductor device>

The present invention also provides a semiconductor device which is produced by using the foregoing printed wiring board of the present invention. Such an inventive semiconductor device can be used, remaining the formed protective layer.

As described above, the printed wiring board of the present invention is a high reliable printed wiring board having a solder resist film with a two-layered structure which combines excellent thermo-discoloration resistivity and patterning resolution on account of the two-layered structure of a white solder resist layer composed of a photosensitive resin composition with good patterning resolution and a protective layer composed of a silicone resin composition having good heat resistance formed on the white solder resist layer. Accordingly, such an inventive printed wiring board can be favorably used as a material of a semiconductor device such as the one to which high density mounting, miniaturization, and high-performance are required, especially high-performance optical semiconductor to which high heat resistance, high reflectance, high reliability, fine patterning, and so on are required. Other than that, the inventive printed wiring board can be used for various fields, for example, a high reflective film and a substrate for a display of a television, a tablet, and a smart-phone; a high reflective film and a substrate for a solar cell, etc. on account of the foregoing properties.

In the printed wiring board of the present invention, the two-layered structure of a white solder resist layer and a protective layer has an effect of complementing each fault with each other, as well as improving thermo-discoloration resistivity and patterning resolution. More specifically, for example, the white solder resist layer which contains an epoxy resin can improve the hardness, and adhesive property between the white solder resist layer and the conductor circuit. Accordingly, it is possible to suppress exfoliation of the solder resist film and to improve the hardness compared to the case in which a solder resist film composed of a silicone resin composition with inferior adhesive property (i.e., only a protective layer) is formed on an insulating substrate having a conductor circuit.

In addition, a silicone resin composition has high gas permeability compared to other resins such as an epoxy resin and a polyester resin. Therefore, when a protective layer composed of the silicone resin composition is formed alone on an insulating substrate having a conductor circuit, the layer permeates oxygen under high temperature to subject a metal layer such as copper foil of a conductor circuit to oxidation, discoloration, and deterioration. On the other hand, the printed wiring board having a solder resist film with a two-layered structure of a white solder resist layer and a protective layer as the present invention enables to suppress gas permeability and deterioration of a conductor circuit by the white solder resist layer.

### EXAMPLE

Hereinafter, the present invention will be explained more specifically by showing Preparation Example, Example, and Comparative Example, but the present invention is not limited thereto.

### [Preparation Example 1]

As organopolysiloxanes containing vinyl group, 50 g of (SiO₂)_{1.0}(Me₂ViSiO_{0.5})_{1.0} and 50 g of dimethylpolysiloxane both terminals of which are blocked with vinyldimethylsiloxy groups and having a viscosity of 100 Pa·s; as a polysiloxane containing SiH group (hydrogenpolysiloxane), 11 g of methylhydrogensilicone oil (trade name: KF-99, manufactured by Shin-Etsu Chemical Co. Ltd.); as an acetylene alcohol type reaction retarder, 0.2 g of ethynylmethyldecylcarbinol; and as a platinum group metal group based catalyst, 0.1 g of 1% by mass octyl alcohol solution of chloroplatinic acid; were blended, and well stirred to obtain a base composition. To this base composition, 6 g of diethylene glycol diethyl ether and 100 g of titanium dioxide (trade name: CR-90, average particle diameter: about 0.25 µm, manufactured by ISHIHARA SANGYO KAISHA, LTD.) were added as a solvent and a filler respectively, and kneaded with a three-roll mill to prepare a silicone resin composition (S1).

### [Preparation Example 2]

As an organopolysiloxane containing vinyl group, 72 g of (PhSiO_{1.5}) _{0.5} (MeViSiO) _{0.2} (Me₂SiO) _{0.3}; as a polysiloxane containing SiH group, 12 g of (PhSiO_{1.5})_{0.3}(Me₂HSiO_{0.5})_{0.7}; as an acetylene alcohol type reaction retarder, 0.2 g of ethynylmethyldecylcarbinol; and as a platinum group metal group based catalyst, 0.1 g of 1% by mass octyl alcohol solution of chloroplatinic acid; were blended, and well stirred to obtain a base composition. To this base composition, 67 g of titanium dioxide (trade name: R-820, average particle diameter: about 0.26 µm, manufactured by ISHIHARA SANGYO KAISHA, LTD.) was added as a filler, and kneaded with a three-roll mill to prepare a silicone resin composition (S2).

### [Preparation Example 3]

As an organopolysiloxane containing vinyl group, 100 g of (PhSiO_{1.5})_{0.45}(Me₂SiO)_{0.5}(MeViSiO)_{0.02}S(Me₂ViSiO_{0.5})_{0.025}; as a polysiloxane containing SiH group, 100 g of (PhSiO_{1.5}) _{0.45} (Me₂SiO) _{0.5} (MeHSiO) _{0.05}; as an acetylene alcohol type reaction retarder, 0.2 g of ethynylmethyldecylcarbinol; and as a platinum group metal group based catalyst, 0.2 g of 1% by mass octyl alcohol solution of chloroplatinic acid; were blended, and well stirred to obtain a base composition. To this base composition, 15 g of diethylene glycol diethyl ether and 200 g of titanium dioxide (trade name: CR-90, average particle diameter: about 0.25 µm, manufactured by ISHIHARA SANGYO KAISHA, LTD.) were added as a solvent and a filler respectively, and kneaded with a three-roll mill to prepare a silicone resin composition (S3).

### [Example 1-1]

Onto a FR-4 copper clad laminated substrate on which the surface of the copper foil had been previously softetched by an etchant composed of sulfuric acid and aqueous hydrogen peroxide, a white photosensitive resin composition (trade name: PSR-4000 LEW5, manufactured by TAIYO INK MFG. CO., LTD.) was printed so as to form a film with a thickness of 20 µm on the entire surface of the substrate by using a 100 mesh polyester (bias-made) plate, and then dried by a circulating hot air oven at 80°C for 10 minutes. Subsequently, this substrate was illuminated by ultraviolet ray in an accumulated exposure of 500 mJ/cm² with an exposure equipment, and heat cured at 150°C for 50 minutes to form a white solder resist layer. Then, onto the white solder resist layer, the silicone resin composition (S1) obtained by Preparation Example 1 was printed so as to form a film with a thickness of 20 µm on the entire surface of the substrate by using a 100 mesh polyester (bias-made) plate, and cured by a circulating hot air oven at 150°C for 4 hours to form a protective layer and to obtain a test piece. To the obtained test piece, the following evaluations of various properties were performed. The results are shown in Table 1.

### (Evaluation of thermo-discoloration resistivity)

The reflectance at an average wavelength of blue LED (450 nm) of the obtained test piece was measured by a reflectometer X-rite 8200 (an integrated-sphere spectrometer, manufactured by X-Rite Inc. (US)). In the same manner, the reflectance after a heat treatment at 150°C for 1000 hours was measured. The reflectance change before and after the heat treatment was calculated by the following (equation 1).

The reflectance change = {(the reflectance at 450 nm after the heat treatment)/(the reflectance at 450 nm before the heat treatment)}×100 (%) (equation 1)

### (Evaluation of discoloration of conductor circuit (copper foil))

The obtained test piece was subjected to a heat treatment at 200°C for 3 hours, then the white solder resist layer and the protective layer were removed by a cutter, and the surface of the copper foil of a conductor circuit was observed visually to evaluate the color change of the copper foil of the test piece after the heating from FR-4 copper clad laminated substrate.

### (Evaluation of adhesive property to copper foil)

The tape-peeling strength of the obtained test piece was measured according to the test method for adhesive property of a solder resist and symbol mark described in JIS C 5012. The existence of lifting of a solder resist layer and a protective layer, and the printed coating film on the tape were examined.

### [Example 1-2]

A test piece was prepared as in the same manner as Example 1-1, except that the silicone resin composition (S2) obtained by Preparation Example 2 was used in the formation of a protective layer. The obtained test piece was evaluated as in the same manner as Example 1-1. The results are shown in Table 1.

### [Example 1-3]

A test piece was prepared as in the same manner as Example 1-1, except that the silicone resin composition (S3) obtained by Preparation Example 3 was printed so as to form a film with a thickness of 10 µm in the formation of a protective layer. The obtained test piece was evaluated as in the same manner as Example 1-1. The results are shown in Table 1.

### [Comparative Example 1-1]

Onto a FR-4 copper clad laminated substrate on which the surface of the copper foil had been previously softetched by an etchant composed of sulfuric acid and aqueous hydrogen peroxide, a white photosensitive resin composition (trade name: PSR-4000 LEW5, manufactured by TAIYO INK MFG. CO., LTD.) was printed so as to form a film with a thickness of 20 µm on the entire surface of the substrate by using a 100 mesh polyester (bias-made) plate, and then dried by a circulating hot air oven at 80°C for 10 minutes. Subsequently, this substrate was illuminated by ultraviolet ray in an accumulated exposure of 500 mJ/cm² with an exposure equipment, and heat cured at 150°C for 50 minutes to form a white solder resist layer alone and to obtain a test piece. The obtained test piece was evaluated as in the same manner as Example 1-1. The results are shown in Table 1.

### [Comparative Example 1-2]

Onto a FR-4 copper clad laminated substrate on which the surface of the copper foil had been previously softetched by an etchant composed of sulfuric acid and aqueous hydrogen peroxide, the silicone resin composition (S1) obtained by Preparation Example 1 was printed so as to form a film with a thickness of 20 µm on the entire surface of the substrate by using a 100 mesh polyester (bias-made) plate, and cured by a circulating hot air oven at 150°C for 4 hours to form a protective layer alone and to obtain a test piece. The obtained test piece was evaluated as in the same manner as Example 1-1. The results are shown in Table 1.

### [Comparative Example 1-3]

A test piece was prepared as in the same manner as Comparative Example 1-2, except that the silicone resin composition (S2) obtained by Preparation Example 2 was used in the formation of a protective layer. The obtained test piece was evaluated as in the same manner as Example 1-1. The results are shown in Table 1.

### [Comparative Example 1-4]

A test piece was prepared as in the same manner as Comparative Example 1-2, except that the silicone resin composition (S3) obtained by Preparation Example 3 was used in the formation of a protective layer. The obtained test piece was evaluated as in the same manner as Example 1-1. The results are shown in Table 1.

**[Table 1]**

| | Example 1-1 | Example 1-2 | Example 1-3 | Comparative Example 1-1 | Comparative Example 1-2 | Comparative Example 1-3 | Comparative Example 1-4 |
|---|---|---|---|---|---|---|---|
| Reflectance change(%) | 96 | 94 | 96 | 65 | 97 | 95 | 96 |
| Color change of copper foil | none | none | none | none | exist | exist | exist |
| Lifting of printed coating film | none | none | none | none | exist | exist | exist |
| Resin on tape | none | none | none | none | exist | none | none |

As shown in Table 1, in Comparative Example 1-1, which only had a white solder resist layer composed of a photosensitive resin composition, low thermo-discoloration resistivity and lowering of a reflectance of a LED were observed. In Comparative Example 1-2, Comparative Example 1-3, and Comparative Example 1-4, which only had a protective layer composed of a silicone resin composition, discoloration and degradation of copper foils of conductor circuits were observed due to high gas permeabilities, although the thermo-discoloration resistivity were high. It was also observed that the adhesive properties with copper foil were low. On the other hand, in Example 1-1, Example 1-2, and Example 1-3, which had a two-layered structure of a white solder resist layer and a protective layer, high thermo-discoloration resistivity and good adhesive property to copper foil were observed, and discoloration and degradation of a conductor circuit were suppressed.

### [Example 2-1]

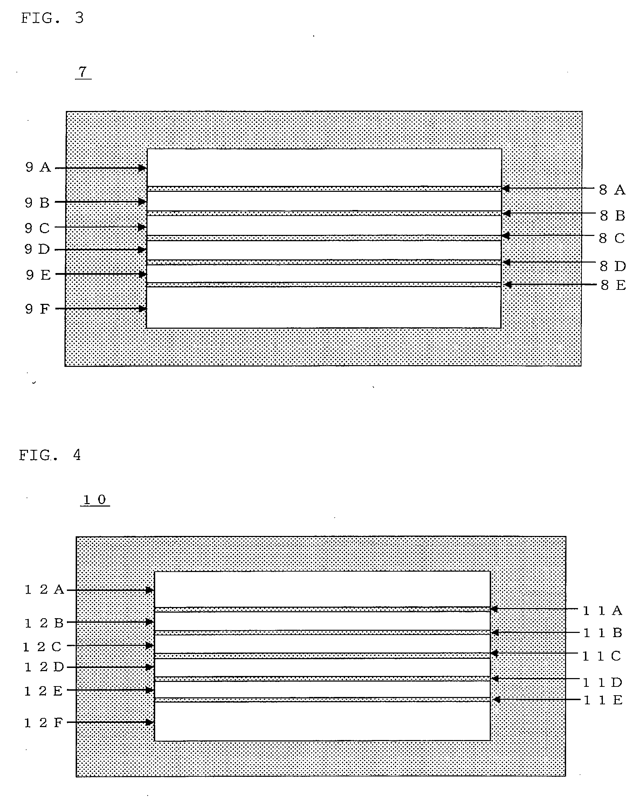

Onto a FR-4 copper clad laminated substrate, a white photosensitive resin composition (trade name: PSR-4000 LEW5, manufactured by TAIYO INK MFG. CO., LTD.) was printed so as to form a film with a thickness of 20 µm on the entire surface of the substrate by using a 100 mesh polyester (bias-made) plate, and then dried by a circulating hot air oven at 80°C for 10 minutes to form a white solder resist layer. Subsequently, this substrate was illuminated by ultraviolet ray in an accumulated exposure of 500 mJ/cm² with an exposure equipment by using a photomask shown in FIG. 3, and heat cured at 150°C for 50 minutes to form a pattern of the white solder resist layer. Then, onto the white solder resist layer, the silicone resin composition (S1) obtained by Preparation Example 1 was printed so as to form a film with a thickness of 20 µm by using a polyester mesh plate for printing, and cured by a circulating hot air oven at 150°C for 4 hours to form a protective layer having a pattern and to obtain a test piece.

FIG. 3 shows the photomask used for the exposure of the white solder resist layer in Example 2-1. The photomask 7 used in the Example had the horizontal length of 140 mm and the vertical length of 50 mm. In the photomask 7, each of the line parts 8A, 8B, 8C, 8D, and 8E had a width of 100 µm and a length of 100 mm, each of the space parts 9A and 9F had a width of 24 mm and a length of 100 mm, and each of the space parts 9B, 9C, 9D, and 9E had a width of 400 µm and a length of 100 mm.

In the polyester mesh plate for printing used for forming the protective layer in Example 2-1, the polyester mesh plate shown in FIG. 4 had been attached to a stainless mesh plate with the horizontal length of 140 mm and the vertical length of 50 mm. The polyester mesh plate 10 used in the Example had the horizontal length of 140 mm and the vertical length of 50 mm. In the polyester mesh plate 10, each of the line parts 11A, 11B, 11C, 11D, and 11E had a width of 200 µm and a length of 100 mm, each of the space parts 12A and 12F had a width of 23.95 mm and a length of 100 mm, and each of the space parts 12B, 12C, 12D, and 12E had a width of 300 µm and a length of 100 mm.

### (Evaluation of pattern resolution)

The existence of a resist residue at the aperture of the test piece obtained above was observed. The results are shown in Table 2.

### [Example 2-2]

A test piece was prepared as in the same manner as Example 2-1, except that the silicone resin composition (S2) obtained by Preparation Example 2 was used in the formation of a protective layer. The obtained test piece was evaluated as in the same manner as Example 2-1. The results are shown in Table 2.

### [Example 2-3]

A test piece was prepared as in the same manner as Example 2-1, except that the silicone resin composition (S3) obtained by Preparation Example 3 was used in the formation of a protective layer, and the following polyester mesh plate was used as a polyester mesh plate for printing: the horizontal length of 140 mm, the vertical length of 50 mm; each of the line parts 11A, 11B, 11C, 11D, and 11E had a width of 300 µm and a length of 100 mm; each of the space parts 12A and 12F had a width of 23.9 mm and a length of 100 mm; and each of the space parts 12B, 12C, 12D, and 12E had a width of 200 µm and a length of 100 mm. The obtained test piece was evaluated as in the same manner as Example 2-1. The results are shown in Table 2.

### [Comparative Example 2-1]

Onto a FR-4 copper clad laminated substrate, a white photosensitive resin composition (trade name: PSR-4000 LEW5, manufactured by TAIYO INK MFG. CO., LTD.) was printed so as to form a film with a thickness of 20 µm on the entire surface of the substrate by using a 100 mesh polyester (bias-made) plate, and then dried by a circulating hot air oven at 80°C for 10 minutes to form a white solder resist layer. Subsequently, this substrate was illuminated by ultraviolet ray in an accumulated exposure of 500 mJ/cm² with an exposure equipment by using the same photomask used in Example 2-1, and heat cured at 150°C for 50 minutes to form a white solder resist layer alone being provided with a pattern and to obtain a test piece. The obtained test piece was evaluated as in the same manner as Example 2-1. The results are shown in Table 2.

### [Comparative Example 2-2]

Onto a FR-4 copper clad laminated substrate, the silicone resin composition (S1) obtained by Preparation Example 1 was printed so as to form a film with a thickness of 20 µm by using a polyester mesh plate for printing, and cured by a circulating hot air oven at 150°C for 4 hours to form a protective layer alone being provided with a pattern and to obtain a test piece. The obtained test piece was evaluated as in the same manner as Example 2-1. The results are shown in Table 2.

In the polyester mesh plate for printing used for forming the protective layer in Comparative Example 2-2, the polyester mesh plate shown in FIG. 4 had been attached to a stainless mesh plate with the horizontal length of 140 mm and the vertical length of 50 mm. The polyester mesh plate 10 used in the Comparative Example had the horizontal length of 140 mm and the vertical length of 50 mm. In the polyester mesh plate 10, each of the line parts 11A, 11B, 11C, 11D, and 11E had a width of 100 µm and a length of 100 mm, each of the space parts 12A and 12F had a width of 24 mm and a length of 100 mm, and each of the space parts 12B, 12C, 12D, and 12E had a width of 400 µm and a length of 100 mm.

### [Comparative Example 2-3]

A test piece was prepared as in the same manner as Comparative Example 2-2, except that the silicone resin composition (S2) obtained by Preparation Example 2 was used in the formation of a protective layer. The obtained test piece was evaluated as in the same manner as Example 2-1. The results are shown in Table 2.

### [Comparative Example 2-4]

A test piece was prepared as in the same manner as Comparative Example 2-2, except that the silicone resin composition (S3) obtained by Preparation Example 3 was used in the formation of a protective layer. The obtained test piece was evaluated as in the same manner as Example 2-1. The results are shown in Table 2.

**[Table 2]**

| | Example 2-1 | Example 2-2 | Example 2-3 | Comparative Example 2-1 | Comparative Example 2-2 | Comparative Example 2-3 | Comparative Example 2-4 |
|---|---|---|---|---|---|---|---|
| Resist residue | none | none | none | none | exist | exist | exist |

As shown in Table 2, in each Comparative Example 2-2, Comparative Example 2-3, and Comparative Example 2-4, which only had a protective layer composed of a silicone resin composition, a resist residue was observed at the aperture and it was confirmed that the resolution was not good. On the other hand, in Comparative Example 2-1, which only had a white solder resist layer composed of a photosensitive resin composition, and in each Example 2-1, Example 2-2, and Example 2-3, which had a two-layered structure of a white solder resist layer and a protective layer, a resist residue was not observed at the aperture, and the resolution was excellent.

As described above, in a printed wiring board which only had a white solder resist layer composed of a photosensitive resin composition, thermo-discoloration resistivity was low, although the resolution was good. In a printed wiring board which only had a protective layer composed of a silicone resin composition, the copper foil of the conductor circuit tended to discolor and deteriorate due to high gas permeability, the adhesive property to copper foil was low, and the resolution was not good, although the thermo-discoloration resistivity was high. On the other hand, in a printed wiring board which had a two-layered structure of a white solder resist layer and a protective layer, excellent thermo-discoloration resistivity and patterning resolution could be combined, discoloration and deterioration of a conductor circuit could be suppressed, and the adhesive property to copper foil could be improve. This has revealed that the inventive printed wiring board is a highly reliable printed wiring board which can be used for optical semiconductor device which requires superior thermo-discoloration resistivity, a high-performance semiconductor device which requires reliability and fine patterning.

It is to be noted that the present invention is not restricted to the foregoing embodiment. The embodiment is just an exemplification, and any examples that have substantially the same feature and demonstrate the same functions and effects as those in the technical concept described in claims of the present invention are included in the technical scope of the present invention.

## Claims

1. A printed wiring board comprising: a conductor circuit on an insulating substrate, a white solder resist layer which is composed of a photosensitive resin composition on the insulating substrate having the conductor circuit, and a protective layer which is composed of a silicone resin composition on the white solder resist layer.

2. The printed wiring board according to claim 1, wherein the white solder resist layer has an aperture having a width of d1 µm, the protective layer has an aperture having a width of d2 µm on the aperture of the white solder resist layer, and the width d1 and the width d2 satisfy 0 ≤ (d2-d1)/2 ≤ 500 µm.

3. The printed wiring board according to claim 2, wherein the aperture of the white solder resist layer is filled with plating.

4. The printed wiring board according to any one of claims 1 to 3, wherein the photosensitive resin composition contains an epoxy resin.

5. The printed wiring board according to any one of claims 1 to 4, wherein the photosensitive resin composition contains a white pigment.

6. The printed wiring board according to any one of claims 1 to 5, wherein the silicone resin composition is an addition curing silicone resin composition.

7. The printed wiring board according to any one of claims 1 to 6, wherein the silicone resin composition contains a silicone resin and a filler.

8. The printed wiring board according to claim 7, wherein the filler contains a white pigment.

9. The printed wiring board according to any one of claims 1 to 8, wherein the conductor circuit has a mounting region to mount an electronic component, and the region excluding the mounting region is coated with the white solder resist layer and the protective layer.

10. A semiconductor device which is produced by using the printed wiring board according to any one of claims 1 to 9.

11. The semiconductor device according to claim 10, wherein the semiconductor device is used, remaining the formed protective layer.

12. A method for producing a printed wiring board, comprising the steps of:
(1) forming a white solder resist layer on an insulating substrate having a conductor circuit by using a photosensitive resin composition,
(2) forming an aperture in the white solder resist layer by a photolithography method, and
(3) forming a protective layer on the white solder resist layer having the aperture by a printing method using a silicone resin composition, the protective layer being formed excluding the aperture and being provided with an aperture.

13. The method for producing a printed wiring board according to claim 12, comprising a step of filling the aperture of the white solder resist layer by plating prior to the step (3) or subsequent to the step (3).
